Europäisches Patentamt

European Patent Office

Office européen des brevets

(19)

(11) **EP 0 691 547 B1**

(12) **FASCICULE DE BREVET EUROPEEN**

(45) Date de publication et mention
de la délivrance du brevet:
**01.10.2003 Bulletin 2003/40**

(51) Int Cl.⁷: **G01R 33/025**

(21) Numéro de dépôt: **95401582.2**

(22) Date de dépôt: **30.06.1995**

(54) **Procédé de compensation des perturbations électromagnétiques dues à des éléments magnétiques et conducteurs mobiles, appliqué notamment à la détermination de la position et de l'orientation d'un viseur de casque**

Verfahren zur Kompensierung von durch magnetische Elemente und bewegliche Leiter verursachten elektromagnetischen Störungen, insbesondere zur Verwendung in einem Helmsichtgerät

Method for compensating electromagnetic disturbances due to magnetic elements and moving conductors, specifically applied to determining the position and orientation of a helmet-mounted visor

(84) Etats contractants désignés:
**BE DE FR GB GR IT NL SE**

(30) Priorité: **05.07.1994 FR 9408286**

(43) Date de publication de la demande:
**10.01.1996 Bulletin 1996/02**

(73) Titulaire: **THALES AVIONICS S.A.**
**78141 Vélizy Villacoublay Cédex (FR)**

(72) Inventeur: **Lescourret, Jean-Louis**
**F-92402 Courbevoie Cedex (FR)**

(74) Mandataire: **Benoit, Monique et al**
**Thomson-CSF Propriété Intellectuelle,**
**13, Avenue du Président Salvador Allende**
**94117 Arcueil Cédex (FR)**

(56) Documents cités:
**FR-A- 2 458 838**   **FR-A- 2 664 044**
**US-A- 4 287 809**   **US-A- 5 126 669**

Printed by Jouve, 75001 PARIS (FR)

## Description

La présente invention concerne un procédé de compensation des perturbations électromagnétiques dues à des éléments magnétiques et conducteurs mobiles. Elle s'applique notamment à la détermination de la position et de l'orientation d'un viseur de casque. Elle s'applique par exemple à la compensation des erreurs de la mesure du champ électromagnétique lorsque celle-ci est perturbée par des pièces magnétiques et conductrices liées rigidement au système de mesure et en mouvement dans le champ électromagnétique à mesurer. Une fois les erreurs compensées, il est alors possible de connaître le champ ambiant réel mesuré par le système de mesure et en déduire les informations recherchées, la position et l'orientation d'un viseur de casque par exemple.

Plus généralement, l'invention s'applique à tous les systèmes nécessitant la connaissance très précise du champ électromagnétique ambiant, cette précision impliquant la compensation des erreurs dues à l'environnement sur la mesure. A ce titre elle s'applique aussi par exemple à des systèmes de détection d'anomalies magnétiques ou à des systèmes de navigation embarqués sur aéronefs.

Des méthodes connues de compensation, destinées par exemple à des systèmes de navigation ou des systèmes de détection d'anomalies magnétiques consistent à modéliser les perturbations du champ magnétique par la somme de plusieurs composantes, une première, indépendante du champ ambiant mais fonction de l'historique des excitations subies par les sources de perturbation magnétique, une deuxième, induite par le champ ambiant et dépendant notamment des caractéristiques magnétiques et géométriques de ces sources de perturbations et enfin une troisième, due à la circulation de courants de Foucault induits.

Ces méthodes reposent notamment sur la dépendance linéaire de l'ensemble des perturbations et du champ ambiant inducteur de façon globale. Un modèle global du champ électromagnétique est réalisé au niveau du centre du système de mesure. Or, en présence de plusieurs éléments de perturbation distincts, ce type de modèle s'avère insuffisant. Par ailleurs, dans le cas de systèmes de navigation ou de détection d'anomalies magnétiques, le champ magnétique ambiant est supposé homogène. Cependant, cette hypothèse n'est pas vérifiée dans le cas général et en présence d'éléments de perturbation multiples. Il s'ensuit alors une faille supplémentaire dans la compensation des erreurs de mesure.

Dans le cas de la détermination de la position et de l'orientation d'un viseur de casque de pilote d'aéronef, une partie du système de mesure, appelée capteur et constituée par exemple de trois bobines, est disposée sur le casque, l'autre partie du système de mesure appelée émetteur et constituée de trois autres bobines émettant un champ magnétique, est fixée dans la cabine, au-dessus de la tête du pilote par exemple. Un courant est successivement généré dans chaque bobine de l'émetteur. Les courants font apparaître successivement trois champs magnétiques associés qui sont captés par les bobines du capteur, liées au casque. Pour chaque champ magnétique émis, les trois composantes d'espace correspondantes sont captées dans les bobines du capteur. Les neuf composantes résultantes permettent alors de déterminer une matrice de passage du trièdre constitué par les bobines de l'émetteur au trièdre constitué par les bobines du capteur et donc de déterminer la position et l'orientation du capteur, et aussi du casque, dans l'espace.

Cependant les mesures de champ réalisées au niveau du capteur sont notamment perturbées par des pièces magnétiques et conductrices situées au voisinage de ce dernier, sur le casque du pilote. Ces pièces perturbatrices sont par exemple des tubes cathodiques blindés par un tube de forte perméabilité magnétique ou encore des boîtiers conducteurs de blindage de fonctions électroniques, des intensificateurs de lumière par exemple.

Le document US 4 287 809 A divulgue un procédé selon le préambule de la revendication 1.

Le but de l'invention est de déterminer un procédé de compensation des perturbations électromagnétiques corrigeant le plus exactement possible les erreurs de mesure provoquées par des éléments magnétiques et conducteurs mobiles dans un champ magnétique ambiant non homogène, c'est à dire dépendant des coordonnées de l'espace.

A cet effet, l'invention a pour objet un procédé de compensations des perturbations de mesure de champ magnétique par un capteur dues à des sources de perturbation liées rigidement au capteur, caractérisé en ce qu'il consiste dans une première étape, les sources étant plongées dans un champ magnétique ambiant quelconque donné, à exprimer la perturbation causée par chaque source comme une fonction explicite du champ magnétique ambiant moyen existant au niveau de la source pour créer un modèle représentatif de son champ perturbateur au centre du capteur, dans une deuxième étape, le capteur étant plongé dans le champ magnétique à mesurer, à déterminer le champ perturbateur causée par chaque source à l'aide de son modèle et du champ magnétique moyen existant à son niveau, dans une troisième étape à sommer les champs perturbateurs aux sources et dans une quatrième étape à retrancher cette somme à la mesure effectuée par le capteur.

L'invention a pour principaux avantages, que les erreurs peuvent être compensées quelles que soient la position et l'orientation des éléments de perturbation dans un vecteur champ magnétique ambiant non homogène fonction des coordonnées de l'espace, le rayonnement du champ étant par exemple dipolaire ou multipolaire ou de structure encore plus complexe, que la détermination de l'effet des éléments de perturbation peut se faire dans un champ différent du champ utilisé opérationnellement, les effets pouvant notamment être identifiés en usine par des moyens spécifiques, qu'elle s'adapte à de nombreux types d'applications, et qu'elle est économique.

D'autres caractéristiques et avantages de l'invention apparaîtront à l'aide de la description qui suit faite en regard de dessins annexés qui représentent :

- la figure 1, un casque de pilote équipé d'un capteur de champ magnétique et d'éléments produisant des perturbations électromagnétiques ;
- la figure 2, une modélisation possible d'une source de perturbation électromagnétique ;
- la figure 3, une représentation d'une perturbation électromagnétique causée par la source précitée.

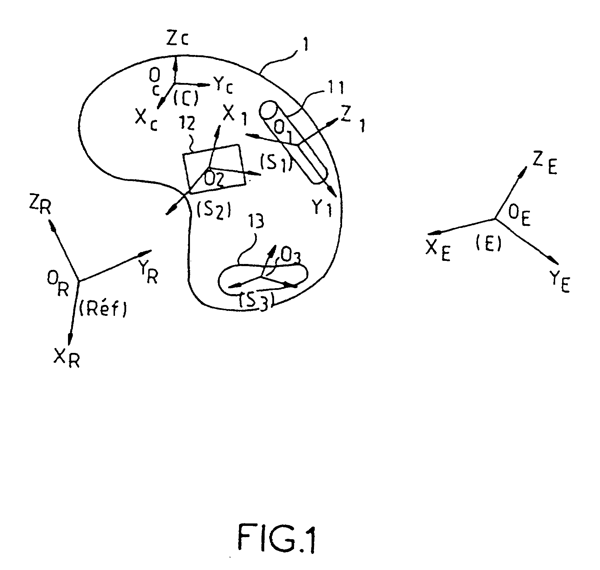

La figure 1 illustre le procédé selon l'invention par son exemple d'application à la détermination de la position et de l'orientation d'un viseur de casque 1 de pilote d'aéronef.

Un capteur est représenté par un repère orthonormé C d'origine $O_c$, le capteur est par exemple fixé sur le casque 1. Des sources de perturbation électromagnétiques 11, 12, 13 sont par ailleurs elles aussi fixées sur le casque 1. A titre d'exemple elles sont limitées à trois. Elles sont représentées par des repères orthonormés $S_1$, $S_2$, $S_3$,...$S_k$ d'origines respectives $0_1$, $0_2$, $0_3$,... $0_k$ et d'axes respectifs $X_1$, $Y_1$, $Z_1$, $X_2$, $Y_2$, $Z_2$ $X_3$, $Y_3$, $Z_3$ et $X_k$, $X_k$, $Z_k$ Les directions de $(X_1, Y_1, Z_1)$, $(X_2, Y_2, Z_2)$, $(X_3, Y_3, Z_3)$, $(X_k, X_k, X_k)$ sont quelconques. Les origines $0_1$, $0_2$, $0_3$... $0_k$ des repères sont par exemple les centres des sources de perturbations 11, 12, 13. Par la suites celles-ci seront confondues avec leurs repères.

Le repère orthonormé C du capteur est mobile dans un repère de référence Réf d'origine $O_R$. Les repères $S_1$, $S_2$, $S_3$, et plus généralement les repères $S_k$ lorsque $k > 3$, des sources de perturbation sont fixes par rapport au repère C du capteur. Un repère orthonormé E d'origine $O_E$, fixe dans le repère de référence Réf est par exemple lié à un émetteur d'induction magnétique, servant notamment à l'aide du capteur fixé sur le casque 1 à déterminer la position et l'orientation de ce dernier comme expliqué précédemment.

Dans une première étape, les sources de perturbation $S_1$, $S_2$, $S_3$, ...$S_k$ étant plongées dans un champ magnétique donné ambiant, le procédé selon l'invention consiste, pour chaque source, à exprimer le modèle de la perturbation d'une source au niveau du capteur C comme une fonction explicite du champ moyen existant, par exemple à l'origine $O_k$ du repère définissant cette source. Cela permet notamment de définir un modèle de la source dépendant explicitement du champ dans lequel est plongé chaque source $S_k$, et par conséquent de pouvoir déterminer les paramètres du modèle de la source en dehors de son environnement électromagnétique d'utilisation, ceux-ci étant indépendants du champ ambiant.

Dans une deuxième étape, le capteur C étant plongé dans le champ magnétique à mesurer, le procédé selon l'invention consiste à déterminer la perturbation causée par chaque source $S_k$ à l'aide de son modèle et du champ magnétique moyen existant à son. niveau. Dans une troisième étape, la somme des perturbations dues aux sources est effectuée. Enfin, dans une quatrième étape, cette somme est retranchée à la mesure réalisée par le capteur C.

Par ce procédé, l'ensemble des paramètres du modèle de source représentatif du phénomène de perturbation produit par cette dernière, est indépendant du champ dans lequel est plongé le capteur et l'ensemble des sources, donc dans l'exemple d'application, cet ensemble de paramètres du modèle est indépendant du champ magnétique dans lequel est plongé le casque. C'est à dire que la détermination du modèle peut se faire notamment dans un champ différent du champ utilisé de manière opérationnelle par le pilote. La première étape du procédé selon l'invention peut ainsi être par exemple réalisée en usine en dehors de l'environnement opérationnel, c'est à dire en dehors de la cabine d'aéronef par exemple. Dans le cas d'application au viseur de casque notamment, les modèles de source peuvent être identifiés en usine par des moyens spécifiques, tels qu'un émetteur quasi-dipolaire rayonnant en espace libre par exemple, et être utilisés dans une cabine d'aéronef quels que soient les champs électromagnétiques existant dans une bande de fréquence contenant la fréquence d'oscillation du champ produit par l'émetteur E fixé dans la cabine.

Selon l'invention, la création d'un modèle représentatif de la perturbation d'une source peut être réalisée notamment en considérant de manière simplifiée qu'une source, et notamment une pièce conductrice, se comporte comme une ou plusieurs boucles élémentaires de courant.

La description qui suit, en s'appuyant sur les figures, présente un mode de mise en oeuvre possible du procédé selon l'invention. A titre d'exemple, il est appliqué à la détermination de la position et de l'orientation d'un viseur de casque.

En espace libre, par exemple, le champ magnétique mesuré par le capteur C est la somme du champ émis par l'émetteur E et des champs produits par chaque source $S_k$ du casque. Ce champ magnétique mesuré peut s'exprimer par la relation suivante :

$$B_c(O_c) = (R_{C/E})^t \, B_E(O_c) + \sum_{k=1}^{NS} R_{c/S_k}^t \, f_k \left( B_k(O_k) \right) S_k \qquad (1)$$

- $B_c(O_c)$ étant le champ total mesuré exprimé dans le repère $C$ du capteur et au centre $O_c$ du capteur ;
- $B_E(O_c)$ étant le champ ambiant, produit par exemple par l'émetteur au centre $O_c$ du capteur et exprimé dans le repère $E$ de l'émetteur, ce champ $B_E(O_c)$ est le champ à mesurer ;
- $(R_{c/E})^t$ étant la matrice transposée de la matrice de passage du repère $E$ de l'émetteur au repère $C$ du capteur ;
- $R_{c/E}$ s'écrit $(R_{c/Ref})_E \, (R_{E/Ref})^t{}_E = (R_{E/Ref})^t{}_{Ref} \, (R_{c/Ref})^t{}_{Ref}$ où $R_{c/Ref}$ est la matrice de passage du repère de référence Ref au repère capteur ($C$), exprimée dans le repère $E$, elle s'écrit $(R_{c/Ref})_E$ ou dans le repère Ref, elle s'écrit $(R_{c/Ref})_{Ref}$.
- $R^t{}_{/E} \, B_E(O_c) = R^t{}_{c/Ref} \, [B_E(Oc)]_{Ref} \, [B_E(O_c)]$ Ref est le champ ambiant exprimé dans le repère de Référence Ref.
- $B_k(O_k)$ est le champ magnétique moyen au centre $O_k$ et exprimé par exemple dans le repère $S_k$;
- la fonction $f_k$ représente la relation existant entre le champ ambiant au point $O_k$ et le champ perturbant au point $O_c$ produit par la source k et exprimé dans le repère ($S_k$).
- $R_{c/S_k}$ est la matrice de passage du repère $S_k$ de la source $S_k$ au repère $C$ du capteur ;
- $NS$ est le nombre de sources perturbatrices.

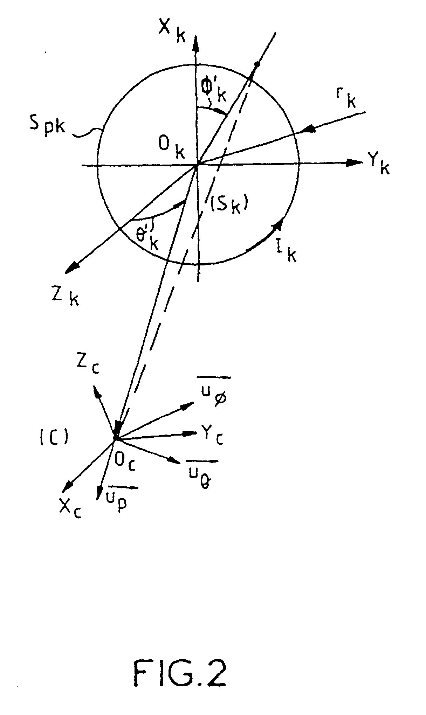

La figure 2 illustre un exemple possible de modèle représentatif de la perturbation d'une source $S_k$. Ce modèle est constitué d'une boucle ou spire élémentaire $SP_k$ de centre $O_k$, origine du repère orthonormé $S_k$ de la source, et de rayon $r_k$. Il est supposé que le champ magnétique moyen $B_k(O_k)$ au centre de la spire $SP_k$ est sensiblement constant dans une sphère de rayon $r_k$. Le champ moyen est donc supposé réparti de façon sensiblement constante dans la spire.

Ce champ moyen est variable dans le temps et provoque dans la spire un courant $i_k$ proportionnel à sa variation selon la loi connue de Lentz. Ce courant provoque à son tour un champ magnétique selon les lois connues de l'électromagnétisme.

En considérant dans un premier temps une spire élémentaire de faibles dimensions, l'expression du courant $i_k$ circulant dans la spire élémentaire plongée dans le champ moyen $B_k(O_k)$ est donnée par la relation suivante

$$R_k \, i_k + L_k \frac{d}{dt} \, i_k = - \frac{d\phi k}{dt} \qquad (2)$$

$R_k$ et $L_k$ étant respectivement la résistance ohmique et l'auto-inductance de la spire $SP_k$, $\phi_k$ étant le flux magnétique traversant la spire.

Pour un champ magnétique $B_k(O_k)$ au niveau de la spire variant sinusoïdalement dans le temps à la pulsation $\omega$, il vient :

$$i_k[R_k + j \, L_k \, \omega] = - j \, A_k \, \omega \, (\vec{B}_k(O_k).\vec{n}_k) \qquad (3)$$

- $A_k$ étant l'aire de la spire $SP_k$ ;
- $\vec{n}_k$ étant la normale à la spire ;
- $(\vec{B}_k(O_k).\vec{n}_k$ représentant le produit scalaire du vecteur champ magnétique ambiant au centre de la spire par la normale $\vec{n}_k$ à cette spire.

De la relation (3), il vient :

$$i_k = - j \, \frac{A_k \, \omega}{R_k + j \, L_k \, \omega} \, \vec{B}_k(O_k).\vec{n}_k \qquad (4)$$

En notant I le module du courant alternatif $i_k$, il vient :

$$I = |i_k| |\alpha| \vec{B}_k(O_k).n_k = |\alpha| |B_k(O_k)|.\text{Cos}(\vec{B}_k(O_k),\vec{n}_k) \qquad (5)$$

avec

$$\alpha = -j \, \frac{A_k \, \omega}{R_k + j \, L_k \, \omega} \tag{6}$$

En considérant un repère radial $\vec{u}_\rho$, $\vec{u}_\theta$, $\vec{u}_\phi$ centré au point $O_c$, centre du capteur, comme l'illustre la figure 2, avec

$\vec{u}_\rho = \dfrac{\overrightarrow{O_k \, O_c}}{\left|\overrightarrow{O_k \, O_c}\right|}$ $\vec{u}_\theta$ et $\vec{u}_\phi$ étant deux autres vecteurs unitaires tels que $\vec{u}_\rho$, $\vec{u}_\theta$, $\vec{u}_\phi$ forment un repère ($u_k$) orthonormé direct

avec $\vec{u}_\theta$ dans le plan ($\vec{u}_\rho$, $\vec{n}_k$), le vecteur champ $(\vec{B}_{Pk})_{uk}$ crée par la spire $SP_k$ s'exprime dans le repère radial $\vec{u}_\rho$, $\vec{u}\theta$, $\vec{u}_\phi$ par trois composantes, une composante $B_\rho$ selon l'axe $\vec{u}_\rho$, une composante $B_\theta$ selon l'axe $\vec{u}_\theta$ et une composante $B_\phi$ selon l'axe $\vec{u}_\phi$. Ce champ $(\vec{B}_{Pk})_{uk}$ modélise la perturbation de la source $k$.

Les lois connues de l'électromagnétisme enseignent que pour $\left|O_k \, O_c\right| > r_k$, les composantes $B_\rho$, $B_\theta$ et $B_\phi$ sont données par les relations suivantes :

$$B_\rho = I \left[ \frac{\mu_o}{4 \, \pi} \, \frac{2 \, \pi \, r_k^2}{\rho} \, \sum_{\ell=o}^{\infty} (-1)^\ell \, \frac{(2\ell+1)!!}{2^\ell (\ell!)} \, \frac{r_k^{2\ell}}{\rho^{2\ell+2}} \, P_{2\ell+1} \left( Cos \, \theta'_k \right) \right] \tag{7}$$

$$B_\theta = - I \left[ \frac{\mu_o}{4 \, \pi} \, \pi \, r_k^2 \, \sum_{\ell=o}^{\infty} (-1)^\ell \, \frac{(2\ell+1)!!}{2\ell(\ell+1)!} \, \frac{1}{\rho^3} \left( \frac{r_k}{\rho} \right)^{2\ell} P^1_{2\ell+1} \left( Cos \, \theta'_k \right) \right] \tag{8}$$

$$B_\phi = o \tag{9}$$

avec $\qquad \rho = \left|\overrightarrow{O_k \, O_c}\right|$

-  $I = \left|i_k\right|$

-  $\theta'_k = (\vec{n}_k, \vec{u}_\rho)$, $\vec{n}_k = \overrightarrow{O_k \, Z_k}$ sur la figure 2 ;

-  $P_\ell^m (x) = $ polynôme de Legendre d'ordre $\ell, m$

-  $(k)!! = k(k-2)(k-4) \, x...5 \, x \, 3 \, x \, 1$, $k$ étant impair.

Les expressions pour $\rho < r_k$ ne sont pas données car elles ne modifient pas le modèle final et de plus dans la réalité $\rho > r_k$.

L'expression du champ $(\vec{B}_{Pk})_c$ de la source $S_k$ ou de la spire $SP_k$, exprimée dans le repère $C$ du capteur, est donnée par la relation suivante :

$$(B_{Pk})_c = (R_{uk/c}) \, (B_{Pk})_{u_k} \tag{10}$$

où $R_{uk/c}$ est la matrice de passage du repère $C$ du capteur, précédemment défini, au repère $u_k = \vec{u}_\rho$, $\vec{u}_\theta$, $\vec{u}_\phi$ précédemment défini.

De façon plus générale, si l'on considère un système de trois spires d'axes de symétrie de révolution ortho-

normés $\vec{n}_x$, $\vec{n}_y$, $\vec{n}_z$, définissant par exemple le repère $(S_k)$, le champ résultant au niveau du capteur $O_c$ est la somme des trois champs produits par les spires ci-dessus.

Dans le repère radial $(u_k)$, le champ dû à la source k est :

$$\left(\bar{B}_{Pk}\left(O_c\right)\right)_{u_k} = \left[\bar{B}^1_{Pk} + \bar{B}^2_{Pk} + \bar{B}^3_{Pk}\right]_{u_k} \qquad (11)$$

$\vec{B}^{1,2,3}_{Pk}$ obéissent aux équations (7), (8), (9).

Dans un premier temps, on supposera pour simplifier l'exposé que $\rho_k = \left|\overrightarrow{O_c\,O_k}\right| >> r_x, r_y, r_z$ rayons des spires. Avec ces hypothèses, les formules (7), (8), (9) donnant les $\vec{B}^{1,2,3}_{Pk}$ ci-dessus se simplifient et s'écrivent de façon connue de l'homme de l'art par :

$$\left(B_{Pk}(O_c)\right)u_k = \frac{1}{\rho_k^{\,3}} \begin{bmatrix} 3 & 0 & 0 \\ 0 & -1 & 0 \\ 0 & 0 & -1 \end{bmatrix} P^t \;\left[S_x\,I_x\,\bar{n}_x + S_y\,I_y\,\bar{n}_y + S_z\,I_z\,\bar{n}_z\right] \qquad (12)$$

avec $P = [\vec{u}_\rho, \vec{u}_\theta, \vec{u}_\phi]$ : matrice de passage du repère $(S_k)$, au repère radial $(u_k)$.

$S_x = \pi r_x^2$, $S_y = \pi r_y^2$, $S_z = r_y^2$. $I_x$, $I_y$, $X_z$ sont les courants $I$ des bobines d'axes $\vec{n}_x$, $\vec{n}_y$, $\vec{n}_z$. $S_x\,I_x$, $S_y\,I_y$, $S_z\,I_z$ sont respectivement les moment magnétiques d'axes $\vec{n}_x\,\vec{n}_x$, $\vec{n}_z$.

Cette matrice P est constante pour la source $k$ puisqu'elle ne dépend que de $\overrightarrow{O_c\,O_k}$, fixe dans le repère $(C)$ du capteur ou du repère $(Sk)$ de la source.

Dans la relation (12), les courants $I_x$, $I_y$, $I_z$ s'expriment selon les relations (4), (5), (6), soit :

$$\begin{cases} I_x = \left|\alpha_x\right|\left|\bar{B}_k\left(O_k\right)\right|\,Cos\left(\theta_x\right)_{Sk} \\[2mm] I_y = \left|\alpha_y\right|\left|\bar{B}_k\left(O_k\right)\right|\,Cos\left(\theta_y\right)_{Sk} \qquad (13) \\[2mm] I_z = \left|\alpha_z\right|\left|\bar{B}_k\left(O_k\right)\right|\,Cos\left(\theta_z\right)_{Sk} \end{cases}$$

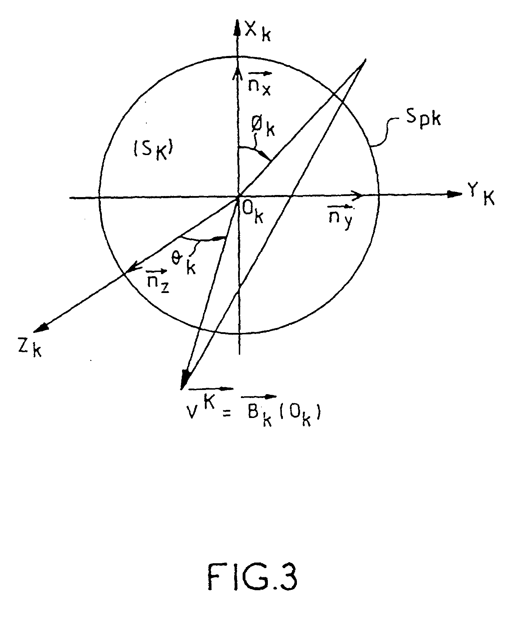

Comme l'illustre la figure 3, le vecteur $\vec{B}_k\,(O_k) = \vec{V}_k$ est repéré dans le repère $(S_k)$ par deux angles $\phi_k$ et $\theta_k$, $\phi_k$ repérant la projection du vecteur $\vec{V}_k$ représentant le champ magnétique dans le plan $O_k$, $X_k$, $Y_k$ et $\theta_k$ l'angle du vecteur $\vec{V}_k$, avec $Z_k = \vec{n}_z$.

On prend les conventions suivantes :

$$\begin{aligned} Cos\left(\theta_z\right)_{Sk} &= Cos\,\theta_k \\ Cos\left(\theta_y\right)_{Sk} &= Sin\,\theta_k\;\;Sin\;\phi_k \qquad (14) \\ Cos\left(\theta_x\right)_{Sk} &= Sin\,\theta_k\;Cos\,\phi_k \end{aligned}$$

En substituant les relations (13) et (14) dans la relation (12), l'expression du champ perturbateur $(B_{Pk}\,(O_c))_C$ au point $O_C$, origine du repère $C$ du capteur, exprimé dans ce repère $C$, est obtenue par la relation suivante en utilisant la relation (10) :

$$\left(\overrightarrow{B_{Pk}}(O_C)\right)_C = \left|\overrightarrow{B_k}(O_k)\right| R_{uk/C} \begin{bmatrix} Sin\ \theta_k\ (a_x\ Cos\ \phi_k + b_x\ Sin\ \phi_k) + c_x\ Cos\ \theta_k \\ Sin\ \theta_k\ (a_y\ Cos\ \phi_k + b_y\ Sin\ \phi_k) + c_y\ Cos\ \theta_k \\ Sin\ \theta_k\ (a_z\ Cos\ \phi_k + b_z\ Sin\ \phi_k) + c_z\ Cos\ \theta_k \end{bmatrix} \quad (15)$$

$\vec{B}_k$ étant le champ ambiant au point $O_k$

et $a_x$, $a_y$, $a_z$, $b_x$, $b_y$, $b_z$, $c_x$, $c_y$, $c_z$ représentent les coefficients de la matrice

$$\frac{1}{\rho_k^3} \begin{bmatrix} 3 & 0 & 0 \\ 0 & -1 & 0 \\ 0 & 0 & -1 \end{bmatrix} \begin{bmatrix} P^t \end{bmatrix} \begin{bmatrix} |\alpha_x|S_x & 0 & 0 \\ 0 & |\alpha_y|S_y & 0 \\ 0 & 0 & |\alpha_z|S_z \end{bmatrix} = \begin{bmatrix} a_x & b_x & c_x \\ a_y & b_y & c_y \\ a_z & b_z & c_z \end{bmatrix}$$

Si l'hypothèse $p_k \gg \{r_x, r_y, r_z\}$ n'est pas respectée, la matrice

$$\begin{bmatrix} 3 & 0 & 0 \\ 0 & -1 & 0 \\ 0 & 0 & -1 \end{bmatrix}$$

dépend de $\rho_k$ et de $\theta'_k$ et $\phi'_k$ définissant les coordonnées de $\overrightarrow{O_cO_k}$, selon les formules (7), (8), (9) que l'homme de l'art saurait appliquer.

Quoi qu'il en soit, cette matrice reste constante pour la source $S_k$. Ainsi l'hypothèse simplificatrice ne change rien à la formule (15) du champ perturbateur.

L'expression du champ $\vec{B}_{Pk}(O_c)$ dans le repère capteur est du même type que celui exprimé dans le repère $(u_k)$, seuls les coefficients $a_x$, $a_y$, $a_z$, $b_x$, $b_y$, $b_z$, $c_x$, $c_y$, $c_z$ seraient modifiés dans le modèle.

Comme ce sont les coefficients inconnus qu'il faut identifier, cela n'a pas d'incidence sur le procédé. Les coefficients sont identifiés dans le repère capteur $(C)$ par exemple.

La formule (15) montre en fait que chaque composante du modèle de la perturbation, le vecteur $B_{Pk}$, s'écrit comme le développement limité à l'ordre 1 des parties réelles et imaginaires de la fonction complexe de Legendre associée définie par :

$$Z_{l,m}(\theta, \phi) = \sum_{\ell=1}^{L} \sum_{m=o}^{\ell} \sqrt{\frac{2\ell+1}{4\pi} \frac{(\ell-m)!}{(\ell+m)!}}\ P_\ell^m(Cos\ \theta)\ e^{jm\phi} \quad (16)$$

avec $e^{jm\phi} = Cos\ m\phi + j\ Sin\ m\phi$

et avec

$$P_\ell^m(x) = \frac{(-1)^m(1-x^2)^{m/2}}{2^\ell\ \ell!} \frac{d^{\ell+m}}{dx^{\ell+m}}\ (x^2 - 1)^\ell \quad (17)$$

A l'ordre 1, $L = 1$ et $m = o$ et $l = 1$.

De façon plus générale, les calculs et expériences réalisés par la Déposante ont montré qu'il est possible d'adopter pour chaque composante du vecteur champ $B_{Pk}$, modèle de la source $S_k$, exprimée dans le repère $C$ du capteur, la définition suivante :

$$\left(B_{Pk}\left(O_C\right)\right)_i = \left|\vec{V}_k\right| \sum_{\ell=1}^{L_k} \sum_{m=o}^{\ell} P_\ell^m(Cos\ \theta_k)\left[A_{\ell,m,i}^k\ Cos\left(m\ \phi_k\right) + C_{\ell,m,i}^k\ Sin\left(m\ \phi_k\ \right)\right] \quad (18)$$

Dans cette formule, $\theta_k$ est l'angle de $\vec{V}_k$ avec l'axe $\vec{O}_z$ du capteur, et $\phi_k$ repère dans le plan de ce même capteur la projection de $\vec{V}_k$ par rapport à $\overrightarrow{O_cX_c}$ selon la figure 3.

$L_k$ est l'ordre du développement du polynôme de Legendre relatif à la source $k$.

Cette nouvelle définition ne change rien aux hypothèses précédentes puisque le repère $(S_k)$ a été supposé quelconque. On peut dans ce cas le considérer confondu avec le repère capteur $(C)$.

- $(B_{Pk}(O_c))_i$ étant la ième composante du vecteur $(B_{Pk}(O_c))$, $i$=1,2,3, cette composante est produite par trois spires de modélisation de la source $S_k$;
- $A_{\ell,m,i}^k$ et $C_{\ell,m,i}^k$ étant des constantes à identifier pour la source $k$.

Ce modèle (18) tient compte du fait que le modèle par 3 spires filiformes (15) est une vue simplifiée des phénomènes physiques réels. En fait, il faut parler plutôt de pseudo-spires qui correspondent aux lignes de courants circulant dans les éléments conducteurs.

On vient d'établir le modèle (18) de la perturbation et on constate qu'il dépend notamment, et de façon explicite, de $\vec{B}_k(O_k)$, c'est à dire du champ extérieur au point $O_k$, centre de la source $k$.

Ce champ est supposé connu :

- lors de l'identification du modèle, ce champ est le champ $B_E$ émis en espace libre par l'émetteur ;
- en utilisation, dans un champ ambiant quelconque, par exemple dans une cabine d'aéronef, c'est le champ émis par l'émetteur $B_E$ auquel s'ajoute éventuellement le champ perturbateur de la cabine.

Dans la première étape de l'invention qui consiste à déterminer les coefficients inconnus du modèle (18), le champ ambiant $B_E$ émis par l'émetteur est connu selon par exemple une méthode enseignée dans le brevet français n° 90.08230 : la mesure du champ $\vec{B}_c(O_c)$ résultant de l'émission de chacune des trois bobines d'émission permet selon cette méthode de fournir une valeur très proche de la position du centre du capteur $(X_c,Y_c,Z_c)$ dans le repère $(E)$ de l'émetteur ou le repère de référence Ref lorsqu'on fait subir au casque des rotations et des translations.

Connaissant une estimation de $X_c,Y_c,Z_c$, on en déduit la valeur du champ ambiant $B_E$ au centre du capteur.

On exprime ensuite le champ $\vec{V}_k = \vec{B}_k(\vec{O}_k)$ en fonction des coordonnées de $O_k$ dans le repère de référence :

$$\overrightarrow{O_RO_k} = \overrightarrow{O_RO_c} + \overrightarrow{O_cO_k}$$

où

$$\left(\overrightarrow{O_c\,O_k}\right) = R_{c/\mathbf{Ref}} \cdot \left(\overrightarrow{O_c\,O_k}\right)_c$$
$$= ROT \cdot \left(\vec{\rho}\right)_c$$

. $(\vec{\rho})_c$ est constant dans le repère capteur ou dans le repère $(S_k)$.

. $ROT$ est la rotation du casque égale à $R_{c/\mathrm{Ref}}$ matrice de passage du repère de référence Ref au repère capteur $(C)$.

Dans la phase d'identification du modèle, $ROT$ est connue, on en déduit les coordonnées de la source $k$ dans le repère de référence (Ref) en fonction des coordonnées $\vec{X}'_k$ de la source dans le repère capteur, inconnues qu'il s'agit d'identifier au cours de cette première étape de l'invention.

Les coordonnées de la source $k$ dans le repère de référence s'expriment par

$$\vec{X}_k = \vec{X}_c + ROT \cdot (\vec{\rho})_c$$

$$\vec{X}_k = \vec{X}_c + ROT \cdot (\vec{X'}_k)$$

En phase d'identification, *ROT* est la rotation connue du casque, $(\vec{X}_c)$, coordonnées du centre du capteur dans le repère de référence, sont connues par exemple de façon approchée par le procédé du brevet français 90.08230. On veut identifier 3 composantes de $\vec{X'}_k = (\vec{\rho})_c$. On en déduit

$$\left(\bar{B}_k(O_k)\right)_c = ROT^{-1} \cdot \left[B_E(\bar{X}_k)\right]_{\mathbf{Ref}}$$

que l'on substitue dans la formule (18).

Après plusieurs itérations sur $\vec{X'}_k$ et sur les $A^k_{\ell,m,i}$ et $C^k_{\ell,m,i}$ l'estimation de $\vec{X}_k$ devient meilleure et les valeurs des paramètres du modèle c'est à dire les composantes $(X_c)_{1,2,3}$ du vecteur $\vec{X}_c$ et les ($A^k_{\ell,m,i}$ et $C^k_{\ell,m,i}$) convergent vers leur vraie valeur.

La convergence est acquise lorsque le champ total mesuré par le capteur et son modèle (1) sont sensiblement égaux en tout point de l'espace, c'est à dire lorsque $(\vec{X'}_k)_i$, $A^k_{\ell,m,i}$ et $C^k_{\ell,m,i}$ minimisent l'écart quadratique moyen entre mesure et champ modélisé selon les relations (1) et (18).

Dans le cas de l'application au viseur de casque, l'expérience montre que pour un tube cathodique de 1/2 ou 1 pouce, le modèle défini par la relation (15) suffit. Pour des objets conducteurs de forme quelconque, le développement à l'ordre 3 des polynômes de Legendre ($L_k$ = 3) dans la relation (18) donne de très bons résultats.

Toujours dans le cadre des applications au viseur de casque, ce modèle doit être réidentifié pour chaque champ $B_E$ émis par chaque bobine de l'émetteur, les bobines d'émission étant au nombre de trois par exemple. Ces champs sont émis séquentiellement ou non. Ils sont par exemple linéairement indépendants, c'est le cas notamment si les bobines d'émission sont quasi-orthogonales.

Dans le cas d'un émetteur à trois bobines, il y a donc 9 termes du type de la relation (18) à définir, trois composantes d'espace du vecteur $B_k$ étant définies pour les trois bobines d'émission. Cela est à réaliser pour toutes les sources de perturbation, *k* variant de *1 à NS, NS* étant le nombre total de ces sources.

Ainsi, pour l'identification du modèle de chaque source $S_k$, il s'agit d'identifier en fait les coefficients $A^k_{\ell,m,i}$ et $C^k_{\ell,m,i}$ de la relation (18), pour les trois bobines d'émission ainsi que les coordonnées $(X'_k)_i$ du centre $O_k$ de la source $S_k$. Dans le cas d'application à un viseur de casque, les coefficients $A^k_{\ell,m,i}$ et $C^k_{\ell,m,i}$ et $(X'_k)_i$ sont par exemple des paramètres représentatifs du casque et de la source $S_k$ pour ce casque donné. Il est possible par exemple de placer le support liant rigidement le capteur $C$ et la source de perturbation $S_k$, c'est à dire le casque, dans le champ des bobines d'émission et d'effectuer des translations et des rotations du casque. Connaissant au préalable le champ, ou son modèle, émis par les bobines, il est possible par exemple de mesurer par différence la perturbation et d'identifier par une méthode classique itérative les paramètres $(X'_k)_i$, $A^k_{\ell,m,i}$ et $C^k_{\ell,m,i}$ qui minimisent l'écart quadratique moyen entre la mesure et le champ préalablement connu ou son modèle. Cette opération, faisant partie de la première étape du procédé selon l'invention, peut par exemple être réalisée en usine, de façon définitive. Les paramètres $(X'_k)_i$ $A^k_{\ell,m,i}$ et $C^k_{\ell,m,i}$ sont par exemple mémorisés dans un circuit résident sur le casque, ce circuit pouvant être une mémoire de type PROM, EPROM, EEPROM notamment. L'identification de ces paramètres $A^k_{\ell,m,i}$ et $C^k_{\ell,m,i}$ et $(X'_k)_i$ et leur mémorisation dans les casques permet de rendre ceux-ci facilement interchangeables. Cela entraîne notamment une plus grande rapidité de changement de casques. Cela entraîne aussi des avantages économiques.

Dans la phase d'utilisation opérationnelle, le pilote porte par exemple le casque qui se trouve plongé dans le champ ambiant de la cabine. Le procédé enseigné dans le brevet français 90.08230 permet de calculer approximativement la position $\vec{X}_c$ et l'orientation *ROT* du casque.

On en déduit les champs perturbateurs de chaque source dont la somme est retranchée à la mesure. Le calcul de $\vec{X}_c$ et *ROT* est alors recalculé, ce qui permet d'obtenir une meilleure précision.

Le procédé de compensation des perturbations électromagnétiques selon l'invention a été décrit par un exemple d'application requérant une grande précision de mesure en vue de la détermination de la position et de l'orientation d'un viseur de casque de pilote d'aéronef, il peut bien sûr être appliqué à de nombreux autres systèmes, exigeant notamment une très bonne précision des mesures de champs électromagnétiques.


**Revendications**

**1.** Procédé de compensation des perturbations de mesures de champ magnétique par un capteur (*C*) dues à des sources de perturbation ($S_1$, $S_2$, $S_3$,...$S_k$) liées rigidement au capteur (*C*), les sources ($S_1$, $S_2$, $S_3$,... $S_k$) étant plongées dans un champ magnétique ambiant ($B_k$) quelconque donné, **caractérisé en ce qu'**il consiste dans une première étape, à exprimer la perturbation causée par chaque source comme une fonction explicite du champ magnétique ambiant moyen existant au niveau de la source pour créer un modèle représentatif de son champ perturbateur au centre du capteur (*C*), dans une deuxième étape, le capteur étant plongé dans le champ magnétique à mesurer, à déterminer le champ perturbateur causé par chaque source à l'aide de son modèle et du champ magnétique moyen existant à son niveau, dans une troisième étape à sommer les champs perturbateurs aux sources (*S*$_1$, *S*$_2$, *S*$_3$, ... *S*$_k$) et dans une quatrième étape à retrancher cette somme à la mesure effectuée par le capteur (*C*).

2. Procédé selon la revendication 1, **caractérisé en ce que** chaque source (*S*$_k$) est modélisée par au moins une spire (*S*$_{Pk}$), les variations du champ ambiant (*B*$_k$) au niveau de la spire créant un courant (*i*$_k$) dans la spire, lequel produit un champ de perturbation.

3. Procédé selon la revendication 2, **caractérisé en ce que** la perturbation causée par une source (*S*$_k$) est modélisée par un vecteur champ magnétique ($\vec{B}_{Pk}(O_C)$) au niveau du capteur (*C*), ce champ étant exprimé de la façon suivante pour chaque composante :

$$\left(B_{Pk}(O_C)\right)_i = \left|\bar{B}_k(O_k)\right| \sum_{\ell=1}^{L_k} \sum_{m=o}^{\ell} P_\ell^m(Cos\,\theta_k)\left[A_{\ell,m,i}^k\,Cos(m\,\phi_k) + C_{\ell,m,i}^k.Sin(m\,\phi_k)\right]$$

- (*B*$_{pk}$ (*O*$_C$))$_i$ étant la ième composante du vecteur

$$\left(\vec{B_{pk}}(O_C)\right)$$

au niveau du capteur (*C*) et produite par au moins une spire de modélisation de la source (*S*$_k$), i =1, 2, 3. ;

- ($\vec{B}_k(O_k)$) étant la valeur du champ magnétique moyen ambiant au centre $O_k$ de la source (*S*$_k$) et $\left|\vec{B}_k(O_k)\right|$ son module ;

- $\theta_k$ étant l'angle entre un axe $\overrightarrow{O_cZ_c}$ du repère capteur (*C*) et le vecteur champ magnétique *B*$_k$ (*O*$_k$) au centre $O_k$ de la spire ;

- $\phi_k$ étant l'angle entre un axe $\overrightarrow{O_cX_c}$ du repère capteur et la projection du vecteur champ magnétique précité *B*$_k$ (*O*$_k$) sur le plan passant par le centre $O_c$ du repère capteur et contenant les axes $\overrightarrow{O_cX_c}$ et $\overrightarrow{O_cY_c}$ (*O*$_c$, *X*$_c$, *Y*$_c$, *Z*$_c$) étant le repère du capteur;

- $P_\ell^m$(*x*) étant un polynôme de Legendre d'ordre $\ell$,*m* défini par

$$P_\ell^m(x) = \frac{(-1)^m(1-x^2)^{m/2}}{2^\ell\,\ell!}\,\frac{d^{\ell+m}}{dx^{l+m}}\,(x^2-1)^\ell\,;$$

- $A_{\ell,m,i}^k$ et $C_{\ell,m,i}^k$ étant des constantes.

4. Procédé selon la revendication 3, **caractérisé en ce que** la source (*S*$_k$) est modélisée par trois spires.

5. Procédé selon l'une quelconque des revendications 3 ou 4, **caractérisé en ce que** pour déterminer les constantes $A_{\ell,m,i}^k$ et $C_{\ell,m,i}^k$ et les coordonnées (*X'*$_k$)$_{1,2,3}$ de la source (*k*), le capteur (*C*) et les sources (*S*$_k$) sont déplacées par translation et rotation dans le champ ambiant préalablement connu, les constantes $A_{\ell,m,i}^k$, $C_{\ell,m,i}^k$ et (*X'*$_k$)$_{1,2,3}$ étant identifiées par une méthode itérative de façon à ce que ces constantes minimisent l'écart quadratique moyen entre la mesure compensée et le champ préalablement connu.

6. Procédé selon l'une quelconque des revendications précédentes, **caractérisé en ce qu'**il s'applique à la détermination de la position et de l'orientation d'un viseur de casque (1) de pilote d'aéronef, un émetteur fixe par rapport à la cabine de l'aéronef étant constitué de trois bobines produisant chacune un champ magnétique, le capteur (C), disposé sur le casque, étant constitué du même nombre de bobines, les mesures par le capteur des champs produits par l'émetteur permettant de définir la position et l'orientation du capteur dans l'espace de la cabine, les perturbations causées par les sources $(S_1, S_2, S_3,... S_k)$ disposées sur le casque (1) étant compensées.

7. Procédé selon la revendication 6, **caractérisé en ce que** les constantes $A^k_{\ell,m,i}$, $C^k_{\ell,m,i}$ sont déterminées de façon indépendante pour le champ produit par chacune des bobines d'émission.

8. Procédé selon la revendication 6 ou 7, **caractérisé en ce que** les constantes $A^k_{\ell,m,i}$, $C^k_{\ell,m,i}$ et $(X_k)_{1,2,3}$ du modèle des sources $(S_1, S_2, S_3,...S_k)$ de perturbation du casque (1) sont déterminées en usine, le casque étant placé dans un champ donné quelconque.

9. Procédé selon l'une quelconque des revendications à 8; **caractérisé en ce que** les constantes $A^k_{\ell,m,i}$, $C^k_{\ell,m,i}$ du modèle sont mémorisées dans des circuits à mémoires disposés dans le casque (1).

**Patentansprüche**

1. Verfahren zur Kompensierung von Störungen bei Magnetfeldmessungen mittels eines Meßfühlers (C), die von Störquellen $(S_1, S_2, S_3, ... S_k)$ herrühren, die fest mit dem Meßfühler (C) verbunden sind, wobei die Quellen $(S_1, S_2, S_3, ... S_k)$ in ein beliebiges gegebenes, umgebendes magnetisches Feld $(B_k)$ getaucht sind, **dadurch gekennzeichnet, daß** in einem ersten Schritt die von jeder Quelle verursachte Störung als eine explizite Funktion des umgebenden, mittleren magnetischen Feldes, das auf Höhe der Quelle existiert, ausgedrückt wird, um ein repräsentatives Modell ihres im Zentrum des Meßfühlers (C) existierenden Störfeldes zu erzeugen, in einem zweiten Schritt, wobei der Meßfühler in das zu messende Magnetfeld eingetaucht ist, das durch jede Quelle verursachte Störfeld mit Hilfe seines Modells und des auf seiner Höhe existierenden mittleren Magnetfeldes bestimmt wird, in einem dritten Schritt die von den Quellen $(S_1, S_2, S_3, ... S_k)$ herrührenden Störfelder addiert werden und in einem vierten Schritt diese Summe von der vom Meßfühler (C) ausgeführten Messung abgezogen wird.

2. Verfahren nach Anspruch 1, **dadurch gekennzeichnet, daß** jede Quelle $(S_k)$ durch mindestens eine Windung $(S_{pk})$ modelliert ist, wobei die Änderungen des umgebenden Feldes $(B_k)$ auf Höhe der Windung einen Strom $(i_k)$ in der Windung erzeugt, der ein Störfeld produziert.

3. Verfahren nach Anspruch 2, **dadurch gekennzeichnet, daß** die durch eine Quelle $(S_k)$ verursachte Störung durch einen Magnetfeldvektor $(\vec{B}_{Pk}(O_C))$ auf Höhe des Meßfühlers (C) modelliert ist, wobei dieses Feld in der folgenden Weise für jede Komponente ausgedrückt ist:

$$(B_{Pk}(O_C))_i = \left|\vec{B}_k(O_k)\right| \sum_{l=1}^{L_k} \sum_{m=o}^{l} P_l^m(Cos\,\theta_k)\left[A_{l,m,i}^k Cos(m\phi_k) + C_{l,m,i}^k \cdot Sin(m\phi_k)\right]$$

- $(B_{Pk}(O_C))_i$ ist dabei die i-te Komponente des Vektors $(\vec{B}_{pk}(O_C))$ auf Höhe des Meßfühlers (C) und durch mindestens eine Modellierungswindung der Quelle $(S_k)$ erzeugt, wobei i = 1, 2, 3;

- $(\vec{B}_k(O_k))$ ist dabei der Wert des mittleren umgebenden Magnetfeldes im Zentrum $O_k$ der Quelle $(S_k)$ und $\left|\vec{B}_k(O_k)\right|$ sein Betrag;

- $\theta_k$ ist der Winkel zwischen einer Achse $\overrightarrow{O_cZ_c}$ des Koordinatenkreuzes des Meßfühlers (C) und dem Magnetfeldvektor $B_k(O_k)$ im Mittelpunkt $O_k$ der Windung;

- $\phi_k$ ist der Winkel zwischen einer Achse $\overrightarrow{O_cX_c}$ des Koordinatensystems des Meßfühlers und der Projektion des oben genannten Magnetfeldvektors $B_k(O_k)$ auf die Ebene, die durch den Mittelpunkt $O_c$ des Koordinatensystems des Meßfühlers führt und die Achsen $\overrightarrow{O_cX_c}$ und $\overrightarrow{O_cY_c}$ enthält, wobei $(O_c, X_c, Y_c, Z_c)$ das Koordinatensystem des Meßfühlers ist;

- $P_l^m(x)$ ist ein Legendre-Polynom der Ordnung 1,m definiert durch

$$P_l^m(x) = \frac{(-1)^m(1-x^2)^{m/2}}{2^l \, l!} \frac{d^{l+m}}{dx^{l+m}} (x^2-1)^l;$$

- $A_{l,m,i}^k$ und $C_{l,m,i}^k$ sind Konstanten.

4.  Verfahren nach Anspruch 3, **dadurch gekennzeichnet, daß** die Quelle ($S_k$) durch drei Windungen modelliert ist.

5.  Verfahren nach einem der Ansprüche 3 und 4, **dadurch gekennzeichnet**, daβ, um die Konstanten $A_{l,m,i}^k$ und $C_{l,m,i}^k$ und die Koordinaten $(X'_k)_{1,2,3}$ der Quelle (k) zu bestimmen, der Meßfühler (C) und die Quellen ($S_k^i$) durch Translation und Rotation in dem vorher bekannten umgebenden Feld verschoben werden, wobei die Konstanten $A_{l,m,i}^k$, $C_{l,m,i}^k$ und $(X'_k)_{1,2,3}$ durch eine iterative Methode bestimmt werden, dergestalt, daß diese Konstanten den mittleren quadratischen Fehler zwischen der kompensierten Messung und dem vorher bekannten Feld minimieren.

6.  Verfahren nach einem der vorangegangenen Ansprüche, **dadurch gekennzeichnet, daß** es angewandt wird für die Bestimmung der Position und der Orientierung eines Helmsichtgerätes (1) eines Luftfahrzeugpiloten, wobei ein bezüglich der Kabine des Luftfahrzeuges feststehender Sender drei Spulen umfaßt, die jede ein Magnetfeld erzeugt, der Meßfühler (C), der sich auf dem Helm befindet, umfaßt die gleiche Anzahl von Spulen, wobei die durch den Meßfühler vorgenommenen Messungen der vom Sender erzeugten Felder es erlauben, die Position und die Orientierung des Meßfühlers im Kabinenraum zu definieren, wobei die durch die Quellen ($S_1$, $S_2$, $S_3$, ... $S_k$), die sich auf dem Helm (1) befinden, hervorgerufenen Störungen kompensiert werden.

7.  Verfahren nach Anspruch 6, **dadurch gekennzeichnet, daß** die Konstanten $A_{l,m,i}^k$, $C_{l,m,i}^k$ in unabhängiger Weise für das von jeder der Sendespulen erzeugte Feld bestimmt werden.

8.  Verfahren nach Anspruch 6 oder 7, **dadurch gekennzeichnet, daß** die Konstanten $A_{l,m,i}^k$, $C_{l,m,i}^k$ und $(X'_k)_{1,2,3}$ des Modells der Störquellen ($S_1$, $S_2$, $S_3$,... $S_k$) des Helms (1) in der Fabrik bestimmt werden, wobei der Helm sich in einem beliebigen gegebenen Feld befindet.

9.  Verfahren nach einem der Ansprüche 6 bis 8, **dadurch gekennzeichnet, daß** die Konstanten $A_{l,m,i}^k$, $C_{l,m,i}^k$ und $(X'_k)_{1,2,3}$ des Modells in Speicherschaltkreisen, die sich im Helm (1) befinden, gespeichert sind.

**Claims**

1.  Method of compensation of perturbations of magnetic field measurements made by a sensor (C) due to sources of perturbation ($S_1$, $S_2$, $S_3$, ... $S_k$) attached rigidly to the sensor (C) , the sources ($S_1$, $S_2$, $S_3$, ... $S_k$) being immersed in any given ambient magnetic field ($B_k$), **characterized in that** it consists in a first step, in expressing the perturbation caused by each source as an explicit function of the average ambient magnetic field existing at the level of the source so as to create a model representative of its perturbing field at the centre of the sensor (C), in a second step, the sensor being immersed in the magnetic field to be measured, in determining the perturbing field caused by each source with the aid of its model and of the average magnetic field existing at the level thereof, in a third step in summing the perturbing fields due to the sources ($S_1$, $S_2$, $S_3$,...Sk) and in a fourth step in deducting this sum from the measurement made by the sensor (C).

2.  Method according to Claim 1, **characterized in that** each source ($S_k$) is modelled by at least one loop ($S_{Pk}$), the variations of the ambient field ($B_k$) at the level of the loop creating a current ($i_k$) in the loop, which produces a perturbing field.

3.  Method according to Claim 2, **characterized in that** the perturbation caused by a source ($S_k$) is modelled by a magnetic field vector ($\bar{B}_{Pk}(Oc)$) at the level of the sensor (C), this field being expressed in the following manner for each component:

$$\left(B_{Pk}(O_C)\right)_i = \left|\bar{B}_k(O_k)\right| \sum_{\ell=1}^{L_k} \sum_{m=o}^{\ell} P_\ell^m(\cos\theta_k)\left[A_{\ell,m,i}^k \cos(m\,\phi_k) + C_{\ell,m,i}^k \cdot \sin(m\,\phi_k)\right]$$

- $(B_{Pk}(Oc))_i$ being the ith component of the vector

$$\left(\vec{B}_{pk}(O_C)\right)$$

at the level of the sensor (C) and produced by at least one loop for modelling the source $(S_k)$, i=1,2,3;

- $(\vec{B}_k(O_k))$ being the value of the average ambient magnetic field at the centre $O_k$ of the source $(S_k)$ and $\left|\vec{B}_k(O_k)\right|$ its modulus;

- $\theta_k$ being the angle between an axis $\overrightarrow{O_c Z_c}$ of the sensor reference frame (C) and the magnetic field vector $B_k$ $(O_k)$ at the centre $O_k$ of the loop;

- $\phi_k$ being the angle between an axis $\overrightarrow{O_c X_c}$ of the sensor reference frame and the projection of the aforesaid magnetic field vector $B_k(O_k)$ onto the plane passing through the centre $O_c$ of the sensor reference frame and containing the axes $\overrightarrow{O_c X_c}$ and $\overrightarrow{O_c Y_c}$, $(O_c, X_c, Y_c, Z_c)$ being the reference frame of the sensor;

- $P^m{}_1(x)$ being a Legendre polynomial of order 1,m defined by

$$P_\ell^m(x) = \frac{(-1)^m (1-x^2)^{m/2}}{2^\ell\,\ell!}\frac{d^{\ell+m}}{dx^{l+m}}(x^2-1)^\ell;$$

- $A^k{}_{l,m,i}$ and $C^k{}_{l,m,i}$ being constants.

4. Method according to Claim 3, **characterized in that** the source $(S_k)$ is modelled by three loops.

5. Method according to either one of Claims 3 or 4, **characterized in that** in order to determine the constants $A^k{}_{l,m,i}$ and $C^k{}_{l,m,i}$ and the co-ordinates $(X'_k)_{1,2,3}$ of the source (k), the sensor (C) and the sources $(S_k)$ are displaced by translation and rotation in the previously known ambient field, the constants $A^k{}_{l,m,l}$, $C^k{}_{l,m,l}$ and $(X'_k)_{1,2,3}$ being identified by an iterative procedure in such a way that these constants minimize the mean square deviation between the compensated measurement and the previously known field.

6. Method according to any one of the preceding claims, **characterized in that** it is applied to the determination of the position and of the orientation of an aircraft pilot's helmet viewfinder (1), a transmitter fixed with respect to the cabin of the aircraft being composed of three coils each producing a magnetic field, the sensor (C), disposed on the helmet, being composed of the same number of coils, the measurements by the sensor of the fields produced by the transmitter making it possible to define the position and the orientation of the sensor in the space of the cabin, the perturbations caused by the sources $(S_1, S_2, S_3,...S_k)$ disposed on the helmet (1) being compensated.

7. Method according to Claim 6, **characterized in that** the constants $A^k{}_{l,m,i}$, $C^k{}_{l,m,i}$ are determined independently for the field produced by each of the transmission coils.

8. Method according to Claim 6 or 7, **characterized in that** the constants $A^k{}_{l,m,i}$, $C^k{}_{l,m,i}$ and $(X'_k)_{1,2,3}$ of the model of the sources $(S_1, S_2, S_3, ... S_k)$ of perturbation of the helmet (1) are determined in the factory, the helmet being placed in any given field.

9. Method according to any one of Claims 6 to 8, **characterized in that** the constants $A^k{}_{l,m,i}$, $C^k{}_{l,m,i}$ and $(X'_k)_{1,2,3}$ of the model are stored in memory circuits disposed in the helmet (1).

FIG.1

FIG.2

FIG.3